# EUROPÄISCHE PATENTSCHRIFT

(11) **EP 3 038 441 B1**
(45) Veröffentlichungstag und Bekanntmachung des Hinweises auf die Patenterteilung: **12.06.2019**
(21) Anmeldenummer: 15003464.3
(22) Anmeldetag: 05.12.2015
(51) Int. Cl.: H05K 7/20, H02G 9/10

(54) **UNTERFLUR-ANORDNUNG VON ELEKTRISCHEN UND/ODER ELEKTRONISCHEN EINRICHTUNGEN INSBESONDERE DER TELEKOMMUNIKATION**
UNDERFLOOR ASSEMBLY OF ELECTRIC AND/OR ELECTRONIC DEVICES, IN PARTICULAR FOR TELECOMMUNICATION
SYSTEME DE DISPOSITIFS ELECTRIQUES ET/OU ELECTRONIQUES EN PARTICULIER DU DOMAINE DE LA TELECOMMUNICATION À MONTER EN SOUS SOL

(30) Priorität: 22.12.2014 DE 102014018931
(43) Veröffentlichungstag der Anmeldung: 29.06.2016
(73) Patentinhaber: Langmatz GmbH, 82467 Garmisch-Partenkirchen (DE)
(72) Erfinder: Baudrexl, Richard, 82377 Penzberg (DE); Fischer, Ludwig, 82487 Oberammergau (DE); Wulf, Stephan, 82467 Garmisch-Partenkirchen (DE)
(74) Vertreter: Flosdorff, Jürgen

(56) Entgegenhaltungen:
- BE-A6- 1 015 842
- US-A- 3 461 952
- US-A1- 2006 180 403
- US-A1- 2007 062 670
- US-A1- 2009 072 685
- US-A1- 2009 126 483

## Beschreibung

Die Erfindung betrifft ein System zur Unterflur-Anordnung von elektrischen und/oder elektronischen Einrichtungen insbesondere der Telekommunikation, mit einem unterflur in den Boden einbaubaren Schacht, der mindestens einen Deckel aufweist, und in dem eine luftdichte Haube angeordnet ist, die die elektrischen und/oder elektronischen Einrichtungen überdeckt. Die luftdichte Haube schützt die elektrischen und/oder elektronischen Einrichtungen bei einem Wassereinbruch in den Schacht vor einer Berührung mit dem Wasser, das in die unten offene, ansonsten geschlossene Haube nur zu einem geringen Teil eindringen kann. Um Montagearbeiten an den elektrischen und/oder elektronischen Einrichtungen ausführen zu können, kann die luftdichte Haube durch geeignete Mittel aus dem Schacht heraus angehoben werden, wozu sie beispielsweise an Schienen verschieblich geführt sein kann und nach dem Ausfahren aus dem Schacht abnehmbar ist. Die Haube ist im eingefahrenen Zustand gegen Auftrieb gesichert.

Bei einem Betrieb der elektrischen und/oder elektronischen Komponenten beispielweise durch eine hohe Belegung von Teilnehmern bei Telekommunikationseinrichtungen entsteht eine große Verlustleistung, die so hohe Temperaturen unter der luftdichten Haube zur Folge haben kann, dass einzelne oder alle elektrischen und/oder elektronischen Komponenten ausfallen und sogar dauerhaft beschädigt werden können.

Die BE 1 015 842 A6 offenbart eine zweiteilige Wärmetauscher-einrichtung, deren zu kühlender Teil außerhalb des Schachtes angeordnet ist. Der andere Teile der Wärmetauschereinrichtung ist zusammen mit den elektrischen/elektronischen Einrichtungen innerhalb eines geschlossenen Gehäuses in dem Schacht angeordnet. Der Deckel des Schachtes enthält keine Öffnungen, durch die Luft ein- und austreten kann.

Die US 2009/0072685 A1 offenbart ein System zur Unterflur-Anordnung von elektrischen und/oder elektronischen Einrichtungen, die in einem Gehäuse untergebracht sind, dessen Deckel aufklappbar ist. Damit ist dieses Gehäuse nicht luftdicht, so dass bei einem Wassereinbruch in den Schacht die elektrischen/elektronischen Einrichtungen überflutet würden. Innerhalb des Gehäuses befindet sich ein Teil einer Wärmetauschereinrichtung, deren anderer Teil sich außerhalb des Schachtes befindet. Die Schachtdeckel haben keine Belüftungsöffnungen.

Die US 3,461,952 offenbart einen Schacht mit Kühlmitteln, bei dem ein Teil einer Wärmetauscheinrichtung innerhalb des Schachtes und ein anderer Teil unterflur neben dem Schacht in dem Boden eingebaut ist. Auch dieser Schacht hat einen Deckel ohne Belüftungsöffnungen.

Der vorliegenden Erfindung liegt die Aufgabe zugrunde, die schädliche Wärme wirkungsvoll abzuführen und dabei den Schutz vor dem eindringenden Wasser beizubehalten.

Diese Aufgabe wird erfindungsgemäß durch die Merkmale des Patentanspruchs 1 gelöst.

Vorteilhafte Ausgestaltungen der Erfindung sind in den Unteransprüchen gekennzeichnet.

Die Erfindung sieht vor, dass innerhalb der luftdichten Haube ein Teil eines Leitungssystems angeordnet ist, das Bestandteil einer Wärmetauschereinrichtung ist, deren anderer Teil sich außerhalb der Haube befindet. Diese Wärmetauschereinrichtung hat bevorzugt eine Pumpe, die ein Kühlmedium durch einen teilweise innerhalb der luftdichten Haube und teilweise außerhalb davon angeordneten Rezirkulationskreis fördert, wobei ein gekühltes Medium in das Leitungssystem innerhalb der Haube einströmt, dort durch die Verlustleistung der elektrischen und/oder elektronischen Komponenten erwärmt wird und außerhalb der Haube gekühlt wird.

Die Kühlleitungen oder Kühlrippen der Wärmetauschereinrichtung können im oberen Bereich der Haube angeordnet sein, wohin die Abwärme der elektrischen und/oder elektronischen Einrichtungen aufsteigt. Erfindungsgemäß ist ein Gebläse innerhalb der Haube angeordnet, das eine Luftströmung in der Haube erzeugt, in der sich die Kühlleitungen befinden.

Der Erfindung sieht außerdem vor, dass der Teil des Leitungssystem mit dem erwärmten Medium und die zur Zirkulation des Mediums vorgesehene Pumpe in dem Schacht angeordnet sind, wo das Leitungssystem durch eine Luftströmung gekühlt wird. Hierzu ist mindestens ein Lüfter in dem Schacht angeordnet, der Luft aus der Umgebung des Schachts durch eine Lufteintrittsöffnung in dem Schachtdeckel ansaugt und gegen die Leitungen mit dem warmen Medium richtet, wobei die erwärmte Luft aus dem Schacht ausströmt.

Die Stromversorgung der Pumpe kann problemlos über elektrische Einrichtungen erfolgen, die sich in dem Schacht befinden, und sie kann z.B. von einem in dem Schacht angeordneten Rechner gesteuert werden.

In weiteren Einzelheiten wird vorgeschlagen, dass die elektrischen und/oder elektronischen Einrichtungen in dem Schacht auf einer Montagebasis angeordnet sind, die mittels eines Motors anhebbar und absenkbar ist. Hierdurch kann die Montagebasis mit den elektrischen und/oder elektronischen Einrichtungen im Bodenbereich des Schachtes positioniert werden, solange sich kein Wasser in dem Schacht befindet. Die hat den Vorteil, dass sich die Wärme in der größtmöglichen Entfernung von den elektrischen und/oder elektronischen Einrichtungen in der luftdichten Haube ansammelt, um auf die oben beschriebene Weise abgeführt zu werden. Wenn ein Wassereinbruch zu befürchten oder durch in dem Schacht angeordnete Sensoren festgestellt wird, wird die Montageplatte mit den elektrischen und/oder elektronischen Einrichtungen soweit in die luftdichte Haube hinein angehoben, dass sie vor dem Wasser sicher geschützt ist.

Außerdem wird mit großem Vorteil vorgeschlagen, dass in dem Schacht der bereits oben erwähnte Rechner, vorzugsweise ein Industrie-PC angeordnet ist, der mit dem Motor zu dessen Steuerung und mit einer Sensor-Peripherie verbunden ist. Außer dem wenigstens einen, oben erwähnten Wasserstand-Sensor sollten mehrere Temperatursensoren in der luftdichten Haube in verschiedenen Höhen vorgesehen sein. Diese Temperatur-Messwerte können zur Steuerung der Wärmetauschereinrichtung herangezogen werden. Wenn sich die Temperatur über den elektrischen und/oder elektronischen Einrichtungen nicht in dem erforderlichen Maß senken lässt, schaltet der PC einzelne oder alle elektrischen und/oder elektronischen Komponenten ab oder setzt einen Alarm an eine übergeordnete Leitwarte ab, die diese Abschaltung vornimmt.

Die mit dem PC verbundene Sensor-Peripherie kann außer den Wasserstandsensoren und Temperatursensoren ferner Feuchtigkeitssensoren, Staubsensoren, Luftströmungssensoren, Lüfterüberwachungssensoren, Motorüberwachungssensoren und Positionssensoren für die Montagebasis aufweisen, wobei die Montagebasis zweckmäßigerweise durch eine Platte gebildet ist.

Wenn der bzw. die Luftströmungssensoren eine unzureichende Luftströmung feststellen, kann der PC einen zusätzlichen Hilfslüfter einschalten, der so angebracht ist, dass er warme Luft aus dem Schacht in die Lufteintrittsöffnungen bläst. Damit können z.B. durch Schnee oder Blätter verstopfte Lufteintrittsöffnungen freigelegt werden.

Außerdem kann der PC mit einer externen Leitwarte in Verbindung stehen, um die von den Sensoren erfassten Daten an die Leitwarte zu senden. Die Leitwarte kann ein Gesamtsystem aus mehreren Unterflur-Anordnungen überwachen und steuern, wobei sie die auf der Montagebasis integrierten Komponenten in einen möglichst idealen, gleichbleibenden Temperaturbereich bringen kann.
Figur 1 zeigt auf rein schematische Weise eine Ausführungsform des erfindungsgemäßen Systems.
Figur 2 zeigt eine nicht zur Erfindung gehörende Ausführungsform.

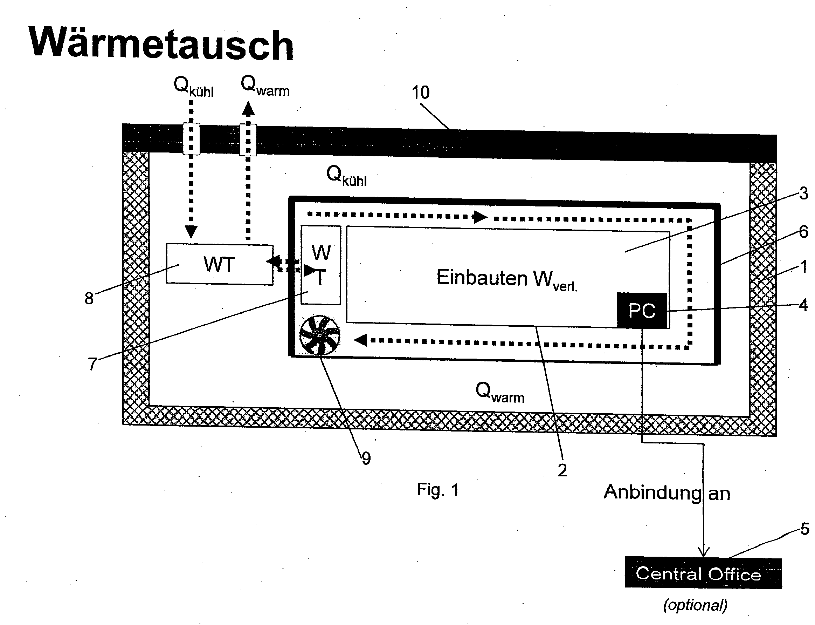

In Figur 1 befindet sich in einem Schacht 1, der in den Boden eingebaut ist, eine Montageplatte 2, auf der elektrische und/oder elektronische Komponenten 3 für die Telekommunikation angeordnet sind. Die Montageplatte 2 kann durch eine nicht dargestellte Hebeanlage, die von einem Motor betätigbar ist, angehoben oder abgesenkt werden. Auf der Montageplatte 2 ist außerdem ein PC 4 angeordnet, der mit einer externen Leitwarte 5 in Verbindung steht.

Die elektrischen und/oder elektronischen Komponenten 3 sind von einer luftdichten Haube 6 überdeckt, die an der Unterseite offen ist. Ansonsten ist die Haube 6 luftdicht geschlossen.

Innerhalb der Haube 6 befindet sich ein Teil 7 einer Wärmetauschereinrichtung, der ein gekühltes Medium enthält. Dieser Teil 7 der Wärmetauschereinrichtung ist mit einem außerhalb der Haube 6 angeordneten anderen Teil 8 des Leitungsystems verbunden, an dem das von einer Pumpe in den Leitungen zirkulierende Medium, das innerhalb der Haube 6 Wärme aufgenommen hat, gekühlt wird.

Innerhalb der Haube 6 ist ein Gebläse 9 angeordnet, das eine Luftströmung in der Haube hervorruft, die sich in dem durch Pfeile dargestellten Kreislauf erwärmt und auf die zu dem äußeren Teil 8 zurückführende Leitung überträgt.

In dem Schacht ist wenigstens ein weiteres, nicht dargestelltes Gebläse angeordnet, das Luft aus der Umgebung des Schachtes ansaugt und auf den zu kühlenden Teil 8 der Wärmetauschereinrichtung richtet, wobei die erwärmte Luft durch eine weitere Öffnung in dem Deckel 10 des Schachtes ausströmt.

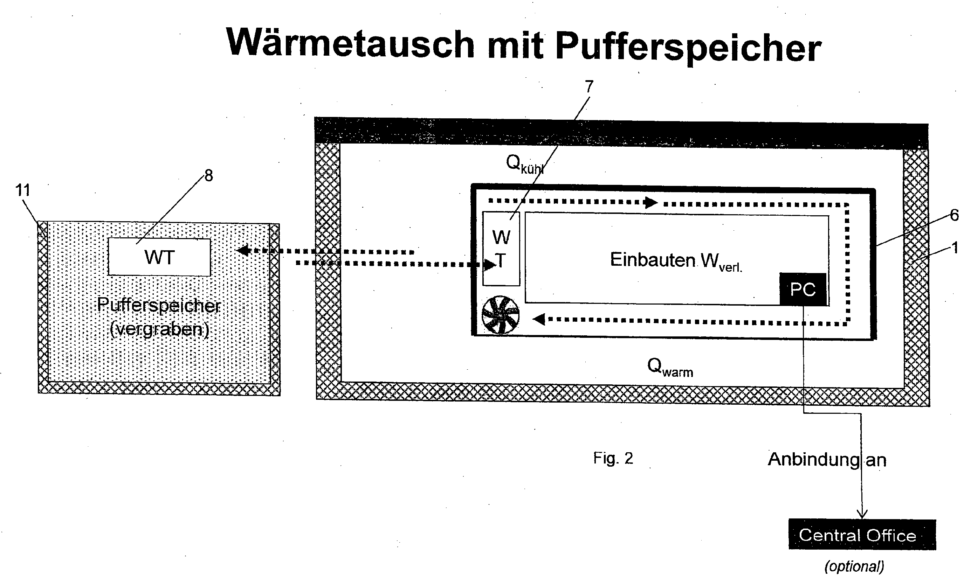

Bei der in Figur 2 dargestellten Ausführungsform ist zum Kühlen des Mediums, das in dem Teil 7 des Wärmetauschers Wärme aus dem Innenraum der Haube 6 aufgenommen hat, neben dem Schacht 1 ein getrennter Pufferspeicher 11 in das Erdreich eingelassen, in dem sich der zu kühlende Teil 8 des Leitungssystems befindet. In dem Pufferspeicher 11 befindet sich Wasser, das in dem Erdboden eine weitgehend gleiche, kühle Temperatur hat und wirkungsvoll das in der Haube 6 erwärmte Medium in der Zirkulationsleitung kühlt. Wenn die Umgebungsluft des Schachtes im Winter sehr kalt ist, kann der Innenraum der Haube 6 mit Hilfe des Wärmepotentials des Pufferspeichers beheizt werden. Auf diese Weise kann für eine weitgehend gleiche Temperatur in dem Schacht 1 gesorgt werden.

Es wird betont, dass die Erfindung nicht auf die beschriebenen und dargestellten Ausführungsformen beschränkt ist, Vielmehr sind alle offenbarten Merkmale auf jede sinnvolle Weise einzeln miteinander kombinierbar.

## Patentansprüche

1. System zur Unterflur-Anordnung von elektrischen und/oder elektronischen Einrichtungen (3) insbesondere der Telekommunikation, mit
einem unterflur in den Boden einbaubaren Schacht (1), der mindestens einen Deckel (10) aufweist, wobei in dem Schacht (1) eine Haube (6) angeordnet ist, die die elektrischen und/oder elektronischen Einrichtungen (3) überdeckt, und mit wenigstens einem Gebläse (9) das zur Erzeugung einer Luftströmung in der Haube (6) angeordnet ist, **dadurch gekennzeichnet,**
**dass** die Haube (6) luftdicht ist, dass innerhalb der luftdichten Haube (6) ein Teil (7) eines Leitungssystem einer Wärmetauschereinrichtung angeordnet ist, deren anderer Teil (8) sich außerhalb der Haube (6) in dem Schacht (1) befindet und deren Leitungen durch eine Luftströmung gekühlt werden, und
**dass** mindestens ein weiteres Gebläse in dem Schacht (1) angeordnet ist, durch das Luft aus der Umgebung des Schachtes (1) durch eine Lufteintrittsöffnung in dem Deckel (10) angesaugt und gegen die Leitungen der Wärmetauschereinrichtung gerichtet wird, wobei die erwärmte Luft durch eine weitere Öffnung in dem Deckel (10) ausströmt.

2. System nach Anspruch 1,
**dadurch gekennzeichnet,**
**dass** die Wärmetauschereinrichtung eine Pumpe aufweist, die ein Kühlmedium durch das Leitungssystem zirkulieren lässt.

3. System nach einem der Ansprüche 1 oder 2,
**dadurch gekennzeichnet,**
**dass** die elektrischen und/oder elektronischen Einrichtungen (3) auf einer Montagebasis (2) angeordnet sind, die mittels eines Motors anhebbar und absenkbar ist.

4. System nach einem der Ansprüche 1 bis 3,
**dadurch gekennzeichnet,**
**dass** in dem Schacht (1) ein PC (4) angeordnet ist, der mit dem Motor (5) zu dessen Steuerung und mit einer Sensor-Peripherie verbunden ist.

5. System nach Anspruch 4,
**dadurch gekennzeichnet,**
**dass** die Sensor-Peripherie wenigstens einen Wasserstand-Sensor aufweist.

6. System nach Anspruch 4 oder 5,
**dadurch gekennzeichnet,**
**dass** die Sensor-Peripherie mehrere Temperatur-Sensoren in der Haube (6) in verschiedenen Höhen aufweist.

7. System nach einem der Ansprüche 4 bis 6,
**dadurch gekennzeichnet,**
**dass** die Sensor-Peripherie wenigstens einen Luftströmungssensor aufweist.

8. System nach einem der Ansprüche 1 bis 7,
**dadurch gekennzeichnet,**
**dass** der PC (4) mit einer externen Leitwarte (5) verbunden ist, um Messwerte aus dem Schacht (1) an die Leitwarte (5) zu senden und um von der Leitwarte (5) Steuersignale zu empfangen.

## Claims

1. A system for the underfloor arrangement of electrical and/or electronic devices (3), particularly for telecommunication, with a duct (1) which is installable in the ground beneath the floor and which includes at least one cover (10), whereby arranged in the duct (1) there is a cap (6), which covers the electrical and/or electronic devices (3), and with at least one fan (9), which is arranged to produce an air flow in the cap (6), **characterised in that** the cap (6) is airtight, that arranged within the airtight cap (6) there is a portion (7) of a conduit system of a heat exchanger device, whose other portion (8) is situated outside the cap (6) in the duct (1) and whose conduits are cooled by an air flow and that at least one further fan is arranged in the duct (1), by which the air is drawn in from the surroundings of the duct (1) through an air inlet opening in the cover (10) and directed towards the conduits of the heat exchanger device, whereby the heated air flows out through a further opening in the cover (10).

2. A system as claimed in Claim 1, **characterised in that** the heat exchanger device includes a pump, which causes a cooling medium to circulate through the conduit system.

3. A system as claimed in one of Claims 1 or 2, **characterised in that** the electrical and/or electronic devices (3) are arranged on a mounting base (2), which may be raised and lowered by means of a motor.

4. A system as claimed in one of Claims 1 to 3, **characterised in that** arranged in the duct (1) there is a PC (4), which is connected to the motor (5) to control it and to a peripheral sensor.

5. A system as claimed in Claim 4, **characterised in that** the peripheral sensor includes at least one water level sensor.

6. A system as claimed in Claim 4 or 5, **characterised in that** the peripheral sensor includes a plurality of temperature sensors in the cap (6) at different heights.

7. A system as claimed in one of Claims 4 to 6, **characterised in that** the peripheral sensor includes at least one air flow sensor.

8. A system as claimed in one of Claims 1 to 7, **characterised in that** the PC (4) is connected to an external control centre (5), in order to transmit measured values from the duct (1) to the control centre (5) and to receive control signals from the control centre (5).

## Revendications

1. Système servant à agencer de manière encastrée des dispositifs (3) électriques et/ou électroniques en particulier de télécommunication, avec
un compartiment (1) pouvant être monté de manière encastrée dans le sol, qui présente au moins un couvercle (10), dans lequel est disposé, dans le compartiment (1), un capot (6), qui recouvre les dispositifs (3) électriques et/ou électroniques, et avec au moins une soufflante (9), qui est disposée dans le capot (6) pour générer un écoulement d'air,
**caractérisé en ce**
**que** le capot (6) est étanche à l'air,
**qu'**est disposée, à l'intérieur du capot (6) étanche à l'air, une partie (7) d'un système de conduits d'un dispositif d'échange de chaleur, dont l'autre partie (8) se trouve à l'extérieur du capot (6) dans le compartiment (1) et dont les conduits sont refroidis par un écoulement d'air, et
**qu'**est disposée dans le compartiment (1) au moins une autre soufflante, par laquelle de l'air provenant de l'environnement du compartiment (1) est aspiré à travers une ouverture d'entrée d'air dans le couvercle (10) et est dirigé dans le sens opposé aux conduits du dispositif d'échange de chaleur, dans lequel l'air réchauffé sort à travers une autre ouverture dans le couvercle (10).

2. Système selon la revendication 1,
**caractérisé en ce**
**que** le système d'échange de chaleur présente une pompe, qui fait circuler un milieu de refroidissement à travers le système de conduits.

3. Système selon l'une quelconque des revendications 1 ou 2,
**caractérisé en ce**
**que** les dispositifs (3) électriques et/ou électroniques sont disposés sur une base de montage (2), qui peut être relevée et abaissée au moyen d'un moteur.

4. Système selon l'une quelconque des revendications 1 à 3,
**caractérisé en ce**
**qu'**est disposé dans le compartiment (1) un PC (4), qui est relié au moteur (5) aux fins de sa commande et à un périphérique à capteurs.

5. Système selon la revendication 4,
**caractérisé en ce**
**que** le périphérique à capteurs présente au moins un capteur de niveau d'eau.

6. Système selon la revendication 4 ou 5,
**caractérisé en ce**
**que** le périphérique à capteurs présente plusieurs capteurs de température dans le capot (6) à des hauteurs différentes.

7. Système selon l'une quelconque des revendications 4 à 6,
**caractérisé en ce**
**que** le périphérique à capteurs présente au moins un capteur d'écoulement d'air.

8. Système selon l'une quelconque des revendications 1 à 7,
**caractérisé en ce**
**que** le PC (4) est relié à une salle de contrôle (5) externe pour envoyer des valeurs de mesure provenant du compartiment (1) à la salle de contrôle (5) et pour recevoir de la salle de contrôle (5) des signaux de commande.
